# EUROPEAN PATENT APPLICATION

(11) **EP 4 761 533 A1**
(43) Date of publication of application: **17.06.2026**
(21) Application number: 24863230.9
(22) Date of filing: 05.09.2024
(51) Int. Cl.: H10H 29/20, H10H 20/83, H10H 20/857

(54) **DISPLAY DEVICE**

(30) Priority: 05.09.2023 US 202363536516 P; 29.08.2024 US 202418820062
(71) Applicant: Seoul Viosys Co., Ltd., Ansan-si, Gyeonggi-do 15429 (KR)
(72) Inventor: CHA, Nam Goo, Ansan-si Gyeonggi-do 15429 (KR); JEON, Hye Chan, Ansan-si Gyeonggi-do 15429 (KR); KWON, Do Hyun, Ansan-si Gyeonggi-do 15429 (KR)
(74) Representative: Stolmár & Partner Patentanwälte PartG mbB
(86) International application number: PCT/KR2024/013440
(87) International publication number: WO 2025/053651

(57) **Abstract**

According to one aspect of the present disclosure, there may be provided a display device including: a display board; a plurality of light sources supported by the display board to generate light; and an electrode body electrically connecting the display board and the plurality of light sources, a peak wavelength difference of the light emitted from the plurality of light sources being 5 nm or less.

## Description

### TECHNICAL FIELD

The present disclosure relates to a display device.

### BACKGROUND ART

Recently, a light emitting diode (LED) has been widely used in a display device. The LED utilizes the property of a compound semiconductor to convert electrical signals into light in the form of such as infrared, visible, or ultraviolet radiation.

As the luminous efficiency of the LED increases, the LED is applied in various fields, including display devices, lighting equipment, and vehicle lamps.

However, there is a problem in a conventional LED where if one of the plurality of LEDs included fails to light up, all of the LEDs must be replaced.

### CONTENTS OF INVENTION

### TECHNICAL PROBLEMS

Embodiments of the present disclosure are designed to provide a display device that does not require the replacement of all light sources even if one of a plurality of light sources fails to illuminate.

Additionally, embodiments of the present disclosure seek to provide the display device that improves luminance by adjusting the direction of refraction.

Furthermore, embodiments of the present disclosure seek to provide the display device that can compensate for light loss even when an unlit light source occurs.

Moreover, embodiments of the present disclosure seek to provide the display device that allows for the easy short-circuiting of the unlit light source.

Additionally, embodiments of the present disclosure seek to provide the display device that can appear as a single light source when the plurality of light sources are illuminated.

Further, embodiments of the present disclosure seek to provide the display device that can prevent the unlit light source from being recognized externally.

### TECHNICAL SOLUTION

According to one aspect of the present disclosure, there may be provided a display device including: a display board; a plurality of light sources supported by the display board to generate light; and an electrode body electrically connecting the display board and the plurality of light sources, wherein a peak wavelength difference of the light emitted from the plurality of light sources is 5 nm or less.

Further, there may be provided the display device in which each of the plurality of light sources includes: a first conductive semiconductor layer; an active layer stacked on the first conductive semiconductor layer; a second conductive semiconductor layer stacked on the active layer; and a light transmitting layer stacked on the second conductive semiconductor layer.

Further, there may be provided the display device in which the plurality of light sources are arranged adjacent to each other, a ragged region is formed in the light transmitting layer, and the ragged region is formed on a surface of the light transmitting layer that faces the plurality of light sources.

Further, there may be provided the display device in which the second conductive semiconductor layer of each of the plurality of light sources is connected to each other and integrally formed, and the light transmitting layer of each of the plurality of light sources is connected to each other and integrally formed.

Further, there may be provided the display device further including: a plurality of first electrodes electrically connected to the first conductive semiconductor layers of the plurality of light sources and the electrode body; and a plurality of second electrodes electrically connected to the second conductive semiconductor layers of the plurality of light sources and the electrode body.

Further, there may be provided the display device in which the plurality of second electrodes are connected to each other and integrally formed.

Further, there may be provided the display device in which the plurality of the first conductive semiconductor layers of light sources are arranged in a radial form about a center of the integrally formed second conductive semiconductor layer.

Further, there may be provided a display device including: a display board; a light emitter supported by the display board to generate light; an electrode body electrically connecting the display board and the light emitter; and a marker disposed on the display board, and including an electrode hole for exposing at least a portion of the electrode body to an outside and a light emitting hole for exposing the light emitter to the outside, wherein the electrode hole and the light emitting hole are formed in different sizes.

Further, there may be provided the display device in which an area of the light emitting hole is larger than an area of the electrode hole.

Further, there may be provided a display device including: a display board; a light emitter supported by the display board to generate light; an electrode body electrically connecting the display board and the light emitter; and a marker disposed on the display board, and including an electrode hole for exposing at least a portion of the electrode body to an outside and a light emitting hole for exposing the light emitter to the outside, wherein the electrode hole and the light emitting hole are arranged to be spaced apart from each other.

Further, there may be provided the display device in which a separation distance between the electrode hole and the light emitting hole is smaller than a diameter of the electrode hole.

Further, there may be provided the display device in which the light emitter includes: a plurality of light sources connected to the electrode body to generate light, the electrode body includes: a plurality of sub-electrodes connected to each of the light sources; and a common electrode connected to at least a portion of the plurality of sub-electrodes, and the electrode holes are formed in plurality to expose at least a portion of the plurality of sub-electrodes to the outside.

Further, there may be provided the display device in which each of the plurality of light sources include: a first conductive semiconductor layer; an active layer stacked on the first conductive semiconductor layer; a second conductive semiconductor layer stacked on the active layer; and a light transmitting layer stacked on the second conductive semiconductor layer, wherein the light emitter further includes: a first electrode electrically connected to the first conductive semiconductor layer; and a second electrode electrically connected to the second conductive semiconductor layer, and wherein the plurality of sub-electrodes include: a plurality of first sub-electrodes connected to one of the first electrode and the second electrode; and a plurality of second sub-electrodes connected to the other of the first electrode and the second electrode, and wherein the plurality of electrode holes include a plurality of first electrode holes for exposing the plurality of first sub-electrodes to the outside.

Further, there may be provided the display device in which a separation distance between the plurality of first electrode holes is smaller than or equal to a separation distance between the light emitting hole and the plurality of first electrode holes.

Further, there may be provided the display device in which the light emitter and the light emitting holes are formed in plurality and are spaced apart from each other, and a separation distance between the plurality of light emitting holes is larger than a separation distance between the plurality of first electrode holes.

Further, there may be provided the display device in which the separation distance between the plurality of light emitting holes is larger than the diameter of the electrode hole.

Further, there may be provided the display device in which a direction in which the plurality of light emitting holes are arranged is the same as a direction in which the plurality of first electrode holes are arranged.

Further, there may be provided the display device in which the plurality of electrode holes includes: a plurality of second electrode holes for exposing the plurality of second sub-electrodes to the outside.

Further, there may be provided the display device in which the light emitting hole is located between the plurality of first electrode holes and the plurality of second electrode holes.

Further, there may be provided the display device in which the light emitter and the light emitting holes are formed in plurality and are spaced apart from each other, and a separation distance between the plurality of light emitting holes is smaller than a separation distance between the first electrode hole and the second electrode hole.

### EFFECTS OF INVENTION

Embodiments of the present disclosure do not require replacement of all of a plurality of light sources if any of the plurality of light sources are not illuminated.

Further, the embodiments of the present disclosure can improve a brightness of a display device.

Further, the embodiments of the present disclosure can compensate for the loss of luminance when an unlit light source occurs in the display device.

Further, the embodiments of the present disclosure can also facilitate short-circuiting an unlit light source of the display device.

Further, the embodiments of the present disclosure can allow the plurality of light sources to appear as a single light source when illuminated.

Further, the embodiments of the present disclosure can also prevent the unlit light source from being recognized externally.

Further, the embodiments of the present disclosure can reduce optical interference between the plurality of light emitters and minimize interference between drive regions, thereby implementing the high quality display device with a distinct contrast ratio and a sharp contrast.

### BRIEF DESCRIPTION OF DRAWINGS

FIG. 1 is a diagram illustrating a display device according to a first embodiment of the present disclosure.
FIG. 2 is a diagram illustrating a plurality of light sources in the display device according to the first embodiment of the present disclosure.
FIG. 3 is a diagram showing that a first electrode of the light emitter in FIG. 2 is connected to a first conductive semiconductor layer and a first sub-electrode, while a second electrode is connected to a second conductive semiconductor layer and a second sub-electrode.
FIG. 4 is a diagram illustrating the state in which the sub-electrode of FIG. 3 is short-circuited.
FIG. 5 is a diagram illustrating a molding laminated to an inclined surface of the sub-electrode of FIG. 4 and a groove of the display substrate.
FIG. 6 is a diagram showing the state in which an unlit light source in FIG. 1 is short-circuited.
FIG. 7 is a diagram illustrating a display device according to a second embodiment of the present disclosure.
FIG. 8 is a diagram illustrating a light emitting hole and an electrode hole of a marker in FIG. 7.
FIG. 9 is a diagram illustrating a display device according to a third embodiment of the present disclosure.
FIG. 10 is a diagram illustrating a light emitting hole and an electrode hole of a marker in FIG. 9.
FIG. 11 is a diagram illustrating a first example of a display device according to a fourth embodiment of the present disclosure, in which the second conductive semiconductor layer is formed integrally.
FIG. 12 is a diagram illustrating a second example of a display device according to the fourth embodiment of the present disclosure, in which the second conductive semiconductor layer is formed integrally.
FIG. 13 is a diagram illustrating a plurality of first conductive semiconductor layers arranged in a radial form with respect to a center of the second conductive semiconductor layer in a display device according to a fifth embodiment of the present disclosure.

### BEST MODE FOR CARRYING OUT THE INVENTION

In the following description, for the purposes of explanation, numerous specific details are set forth in order to provide thorough understanding of various exemplary embodiments or implementations of the present disclosure. As used herein, "embodiments" and "implementations" are interchangeable terms for non-limiting examples of devices or methods employing one or more of the inventive concepts disclosed herein. It will be apparent, however, that various exemplary embodiments may be practiced without these specific details or with one or more equivalent arrangements. In other instances, well-known structures and devices are shown in block diagram form in order to avoid unnecessarily obscuring various exemplary embodiments. Further, various exemplary embodiments may be different, but do not have to be exclusive. For example, specific shapes, configurations, and characteristics of an exemplary embodiment may be used or implemented in another exemplary embodiment without departing from the inventive concepts.

Unless otherwise specified, the illustrated exemplary embodiments are to be understood as providing exemplary features of varying detail of some ways in which the inventive concepts may be implemented in practice. Therefore, unless otherwise specified, the features, components, modules, layers, films, panels, regions, and/or aspects (hereinafter individually or collectively referred to as "elements") of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, and property of the elements, unless specified. Further, in the accompanying drawings, the size and relative sizes of elements may be exaggerated for clarity and/or descriptive purposes. When an exemplary embodiment is implemented differently, a specific process order may be performed differently from the described order. For example, two consecutively described processes may be performed substantially at the same time or performed in an order opposite the described order. In addition, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the DR1-axis, the DR2-axis, and the DR3-axis are not limited to three axes of a rectangular coordinate system, such as the x, y, and z-axes, and may be interpreted in a broader sense. For example, the DR1-axis, the DR2-axis, and the DR3-axis may be perpendicular to one another, or may represent different directions that are not perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," and the like may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (for example, as in "sidewall"), and the like, may be used herein for descriptive purposes, and, thereby, to describe one element's relationship to other element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the exemplary term "below" can encompass both an orientation of above and below. Furthermore, the apparatus may be otherwise oriented (for example, rotated 90 degrees or at other orientations), and, as such, the spatially relative descriptors used herein may likewise interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various exemplary embodiments are described herein with reference to sectional and/or exploded illustrations that are schematic illustrations of idealized exemplary embodiments and/or intermediate structures. As such, variations from the shapes of the illustrations as a result, for example, of manufacturing techniques and/or tolerances, are to be expected. Thus, exemplary embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some exemplary embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (for example, microcode) to perform various functions discussed herein and may optionally be driven by firmware and/or software. It is also contemplated that each block, unit, and/or module may be implemented by dedicated hardware, or as a combination of dedicated hardware to perform some functions and a processor (for example, one or more programmed microprocessors and associated circuitry) to perform other functions. Also, each block, unit, and/or module of some exemplary embodiments may be physically separated into two or more interacting and discrete blocks, units, and/or modules without departing from the scope of the inventive concepts. Further, the blocks, units, and/or modules of some exemplary embodiments may be physically combined into more complex blocks, units, and/or modules without departing from the scope of the inventive concepts.

Unless otherwise defined, all terms (including technical and scientific terms) used herein have the same meaning as commonly understood by one of ordinary skill in the art to which this disclosure pertains. Terms, such as those defined in commonly used dictionaries, should be interpreted as having a meaning that is consistent with their meaning in the context of the relevant art and should not be interpreted in an idealized or overly formal sense, unless expressly so defined herein.

Hereinafter, a display device 1 according to a first embodiment of the present disclosure will be described.

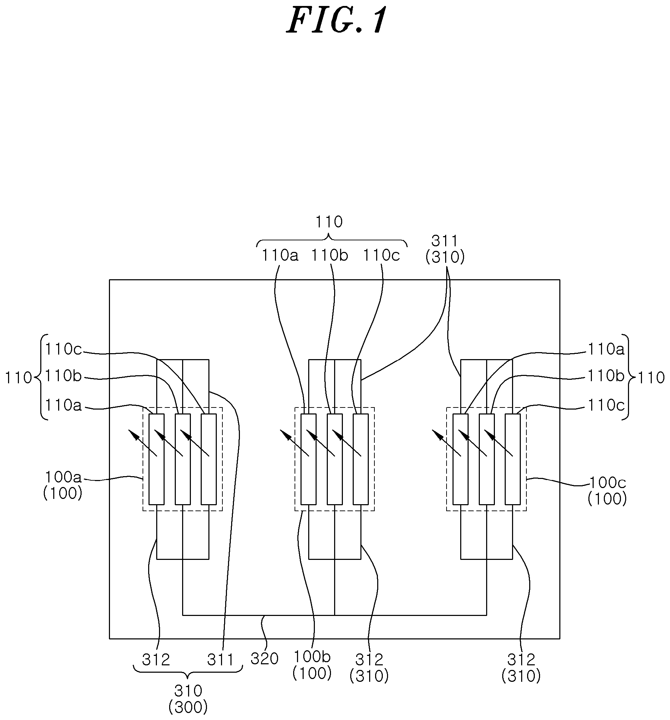

Referring to FIG. 1, the display device 1 according to the first embodiment of the present disclosure can be mounted on signage, augmented reality AR, virtual reality VR, and can display characters, symbols, images, or videos. Additionally, the display device 1 can be mounted in vehicles. Such a display device 1 may be included in rear lights, headlights, rear lamps, tail lamps, and the like. Moreover, the display device 1 mounted in the vehicle can emit red, yellow, or white light to display information such as stop signals or characters to an outside. Furthermore, the display device 1 can reduce optical interference between a plurality of light emitters 100 and minimize interference between driving regions, thereby achieving a high quality display device with a distinct contrast ratio and a sharp contrast. The display device 1 may include the light emitter 100, a display board 200, and an electrode body 300.

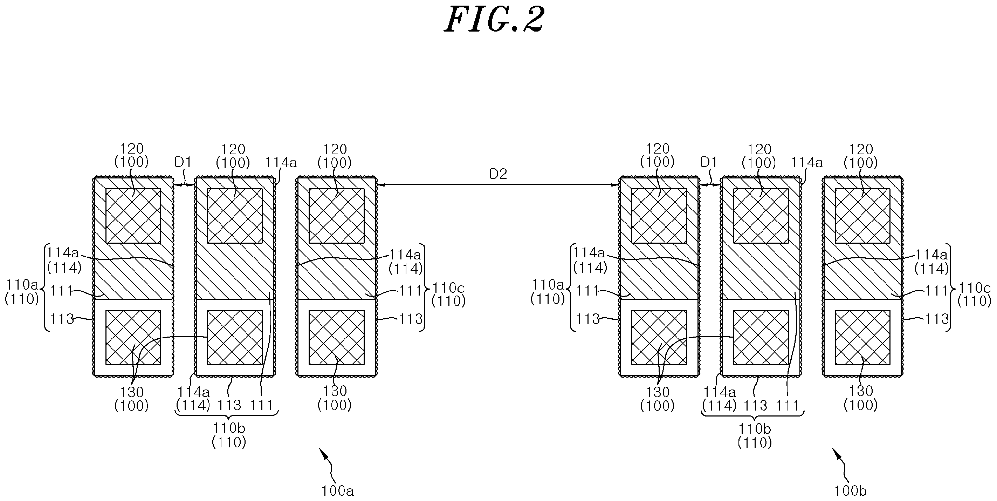

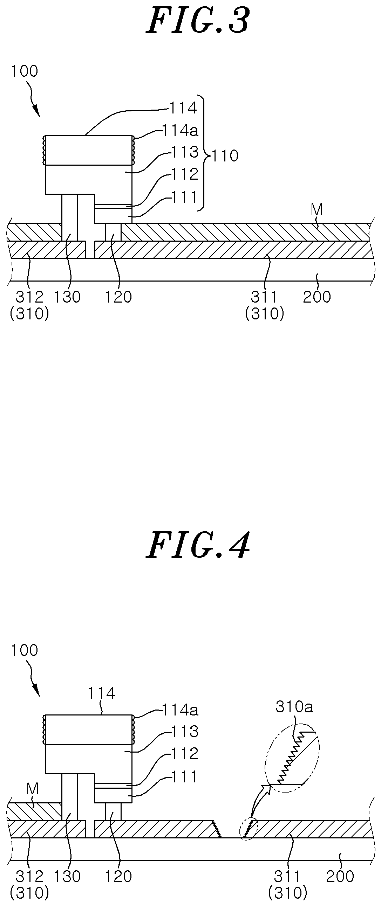

Referring to FIGS. 2 and 3, the light emitter 100 may generate light. The light emitter 100 is formed as a plurality and may be supported by the display board 200. Additionally, the plurality of light emitters 100 may be connected to the electrode body 300 arranged on the display board 200. In other words, the plurality of light emitters 100 may be interconnected through the electrode body 300. Furthermore, the plurality of light emitters 100 may be individually driven for each region to adjust luminance or control the light emitting area. The plurality of light emitters 100 may generate light with different peak wavelengths. The light generated by the plurality of light emitters 100 may have different energy band gaps. For example, a first light emitter 100a, one of the plurality of light emitters 100, may generate red light having a peak wavelength at 600 nm to 750 nm. Further, a second light emitter 100b, another of the plurality of light emitters 100, may generate green light having a peak wavelength at 490 nm to 570 nm. Further, a third light emitter 100c, another of the plurality of light emitters 100, may generate blue light having a peak wavelength from 400 nm to 490 nm. Further, each of the plurality of light emitting emitters 100 may include a plurality of light sources 110, a plurality of first electrodes 120, and a plurality of second electrodes 130.

The plurality of light sources 110 may be arranged adjacent to each other to generate light. A length of the plurality of light sources 110 in a first direction may be longer than a length in a second direction perpendicular to the first direction. For example, the length of the plurality of light sources 110 in the first direction may be formed within 30 µm. Further, the plurality of light sources 110 may be arranged spaced apart in the second direction. The plurality of light sources 110 may be arranged in parallel to each other, but is not limited thereto. A separation distance between the plurality of light sources 110 may be smaller than a separation distance between the plurality of light emitters 100. Since the plurality of light sources 110 can be spaced apart from each other, they may be selectively placed when positioned on the display board 200, which may result in a lower failure rate of the light emitter 100. For example, the plurality of light sources 110 may include the first light source 110a, the second light source 110b, and the third light source 110c, arranged sequentially in the second direction. Although three light sources 110a, 110b, and 110c have been described as an example, they are not strictly limited thereto, nor are they limited in number.

A signal, current, or voltage supplied to the light emitter 100 may be divided and supplied to the plurality of light sources 110 through the electrode body 300, or may be supplied in different amounts. As the signal, current, or voltage supplied to each light source 110 increases, an amount of light emitted by the light source 110 may also increase. For example, the signal, current, or voltage may be supplied evenly divided to the first light source 110a, the second light source 110b, and the third light source 110c, or may be supplied in different amounts. Additionally, any one of the plurality of light sources 110 in the first light emitter 100a and any one of the plurality of light sources 110 in the second light emitter 100b may have different current densities.

The plurality of light sources 110 may generate UVC (200 nm to 280 nm), UVB (280 nm to 315 nm), UVA (315 nm to 420 nm), blue light, green light, yellow light, red light, infrared light, and other types of light. Additionally, a peak wavelength difference of the light emitted by the plurality of light sources 110 constituting a single light emitter 100 may be 5 nm or less. In other words, the plurality of light sources 110 may emit light of the same color. For example, the plurality of light sources 110 included in the first light emitter 100a may have a peak wavelength difference of 5 nm or less and may emit red light. The plurality of light sources 110 included in the second light emitter 100b may have a peak wavelength difference of 5 nm or less and may emit green light. The plurality of light sources 110 included in the third light emitter 100c may have a peak wavelength difference of 5 nm or less and may emit blue light.

The plurality of light sources 110 may include a light emitting structure that includes a substrate and a plurality of layers disposed on the substrate. The light emitting structure may include a first conductive semiconductor layer 111, an active layer 112, a second conductive semiconductor layer 113, and a light transmitting layer 114.

The first conductive semiconductor layer 111 may include a phosphide or nitride based semiconductor such as (Al, Ga, In)P or (Al, Ga, In)N. The first conductive semiconductor layer 111 may be doped in an n-type and may include one or more impurities such as Si, C, Ge, Sn, Te, or Pb. However, it is not limited thereto, the first conductive semiconductor layer 111 may also be doped in p-type by including p-type dopants.

The active layer 112 is a light emitting layer formed between the first conductive semiconductor layer 111 and the second conductive semiconductor layer 113, which may include a phosphide or nitride based semiconductor such as (Al, Ga, In)P or (Al, Ga, In)N, and may include a quantum well structure (QW) including two barrier layers and at least one well layer. Further, the active layer 112 can adjust the wavelength of the emitted light by adjusting the composition ratio of the well layer. On the other hand, the first conductive semiconductor layer 111 and the active layer 112 may form a mesa.

The second conductive semiconductor layer 113 may be a semiconductor layer formed on the active layer. The second conductive semiconductor layer 113 may include a phosphide or nitride based semiconductor such as (Al, Ga, In)P or (Al, Ga, In)N. The second conductive semiconductor layer 113 may be doped with a type opposite to that of the first conductive semiconductor layer 111. For example, the second conductive semiconductor layer 113 may be doped in the p-type by including impurities such as Mg. The second conductive semiconductor layer 113 may be formed as a single layer having a composition such as p-GaN, but it is not limited thereto, and may further include an AlGaN layer therein.

The light transmitting layer 114 may be disposed on the first conductive semiconductor layer 111 or the second conductive semiconductor layer 113. The light transmitting layer 114 may serve as an insulating or conductive substrate for the growth of the first conductive semiconductor layer 111, the active layer 112, and the second conductive semiconductor layer 113, or it may be an insulating or conductive substrate joined by bonding. For example, the light transmitting layer 114 may include one or more of a sapphire substrate, silicon carbide substrate, silicon substrate, gallium nitride substrate, or aluminum nitride substrate. Additionally, the light transmitting layer 114 may include a ragged region 114a.

The ragged region 114a may be formed on an outer surface of the light transmitting layer 114. The ragged region 114a may be formed along an entire peripheral surface of the light transmitting layer 114, but it is not limited thereto. The plurality of light sources 110 may include the ragged region 114a on opposing sides.

A separation distance D1 between the lagged region 114a of the first light source 110a of the first light emitter 100a and the lagged region 114a of the second light source 110b facing the first light source 110a may be smaller than a width of the first light source 110a or the second light source 110b in the second direction. When viewed in cross section, the lagged region 114a may protrude outwardly from the semiconductor layer of the light source.

The separation distance D1 between the plurality of light sources 110a, 110b, and 110c of the first light emitter 100a may be less than a separation distance D2 between the first light emitter 100a and the second light emitter 100b. Due to the ragged region 114a, the light generated by the plurality of light sources 110 can be scattered in the light transmitting layer 114, which can create the effect of making the plurality of light sources 110 appear as a single light source when the plurality of light sources 110 are emitted. Further, the first light emitter 100a and the second light emitter 100b can prevent color mixing by the separation distance D2 therebetween.

The plurality of first electrodes 120 may be electrically connected to the first conductive semiconductor layer 111 of the plurality of light sources 110 and the electrode body 300. In other words, the plurality of first electrodes 120 may be connected to any one of a plurality of sub-electrodes 310 described later. Additionally, the plurality of first electrodes 120 may be connected with each other by the sub-electrodes 310 to prevent short-circuiting.

The plurality of second electrodes 130 may be electrically connected to the second conductive semiconductor layer 113 of the plurality of light sources 110 and the electrode body 300. The plurality of second electrodes 130 may be connected to another one of the plurality of sub-electrodes 310. Further, the plurality of second electrodes 130 may be connected with each other by the sub-electrodes 310 to prevent short-circuiting.

A plurality of light emitters 100 and electrode bodies 300 may be disposed on the display board 200. For example, the display board 200 may be a printed circuit board (PCB) on which electrical circuits are printed. Further, the display board 200 may be a thin-film transistor (TFT) backplane.

The electrode body 300 is electrically connected to a plurality of light sources 110 and can supply signals, current, or voltage to the plurality of light sources 110. For example, the electrode body 300 may be an electric circuit disposed on the display board 200. The electrode body 300 may include the plurality of sub-electrodes 310 and a common electrode 320.

The plurality of sub-electrodes 310 is electrically connected to the plurality of light sources 110 and can transmit signals, current, or voltage, received from the common electrode 320, to the plurality of light sources 110. At least some of the plurality of sub-electrodes 310 may be interconnected through the common electrode 320. In other words, the light sources 110 of the plurality of light emitters 100 on the plurality of sub-electrodes 310 may be connected to each other. The plurality of sub-electrodes 310 may include a plurality of first sub-electrodes 311 and a plurality of second sub-electrodes 312.

The plurality of first sub-electrodes 311 may be electrically connected to one of the first electrode 120 and the second electrode 130 of the light emitter 100. For example, the plurality of first sub-electrodes 311 may be connected to the plurality of first electrodes 120 of the light emitter 100, respectively. In addition, the plurality of first sub-electrodes 311 may be interconnected.

The plurality of second sub-electrodes 312 may be electrically connected to another of the first electrode 120 and the second electrode 130 of the light emitter 100. For example, the plurality of second sub-electrodes 312 may be connected to the plurality of second electrodes 130 of the light emitter 100. Additionally, the plurality of second sub-electrodes 312 may be connected to each other.

The common electrode 320 may be connected to one or more of the plurality of first sub-electrodes 311 and the plurality of second sub-electrodes 312 to transmit a signal, current, or voltage to cause the plurality of light sources 110 to emit light. For example, the common electrode 320 may be electrically connected to the plurality of second sub-electrodes 312.

On the other hand, when any one of the plurality of light sources 110 fails to light up, the sub-electrodes connected to the unlit light source 110 may be cut off to allow the signals, current, or voltage to be transferred to other operable light sources 110. For example, if the first light source 110a of the second light emitter 100b is malfunctioning or fails to light up, one or more of the plurality of sub-electrodes 310 connected to the first light source 110a may be short-circuited. Furthermore, even if an unlit light source 110 occurs, additional current can be supplied to the neighboring light sources to increase the amount of light, so that the loss of light intensity caused by the unlit light source 110 can be compensated by the neighboring light sources 110.

Under the same luminance conditions, the amount of signals, current, or voltage supplied to each operable light source 110 in the light emitter 100 including a short-circuited light source 110 may be greater than the amount supplied to each operable light source 110 in the light emitter 100 that does not include the short-circuited light source 110. For example, the amount of signals, current, or voltage supplied to the second light emitter 100b, which includes the short-circuited first light source 110a, may be greater than the amount supplied to the first light emitter 100a and the third light emitter 100c. In other words, the amount of signal, current, or voltage supplied to the lighted second light source 110b and third light source 110c of the second light emitter 100b may be greater than the amount of signal, current, or voltage supplied to the light source 110 of each of the first light emitter 100a and the third light emitter 100c.

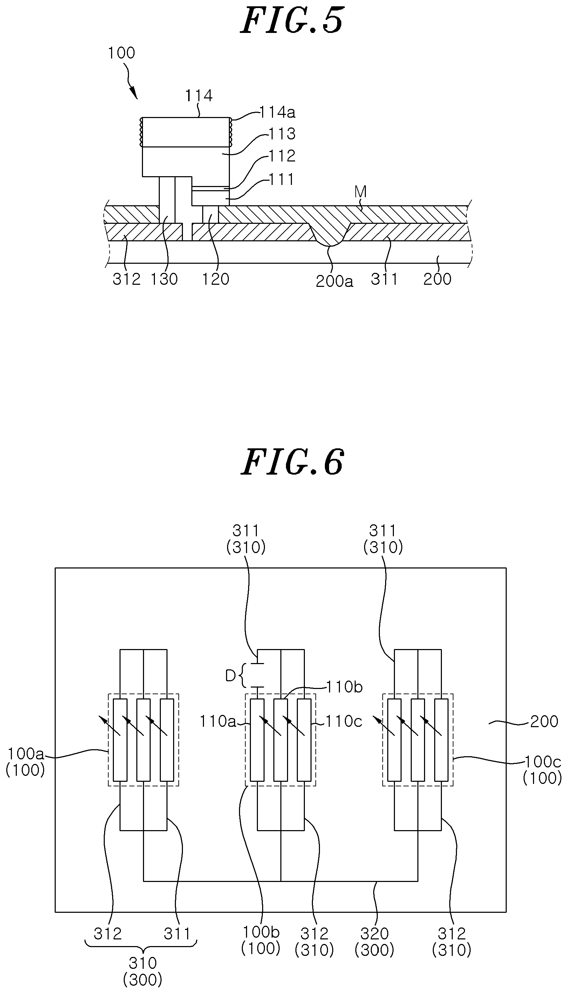

Referring to FIGS. 4 to 6, the sub-electrode 310 may be short-circuited after the removal of a molding layer M laminated on the sub-electrode 310. As the sub-electrode 310 is short-circuited by a laser, a short-circuited region D may be formed on the sub-electrode 310. The method is not necessarily limited to laser processing, and other chemical or physical processes, such as etching, may also be employed. A sloped surface 310a may be formed on the short-circuited sub-electrode 310, and a ragged region may be formed on the sloped surface 310a. Further, as the sub-electrode 310 is short-circuited by the laser, a groove 200a may be formed on the display board 200. The molding layer M may be laminated again on the short-circuited sub-electrode 310. As the molding layer M is laminated on the short-circuited sub-electrode 310, the molding layer M may cover the ragged region of the sloped surface 310a and the groove 200a. Since the molding layer M covers the ragged region on the sloped surface 310a, strong adhesion can be maintained. Further, as the molding layer M covers the groove 200a, the molding layer M can prevent electromigration from occurring in the short-circuited sub-electrode 310.

The molding layer M may be formed from any insulating material, such as PSR, silicone, photoresist, SiO₂, EMC, or polyimide. A height of the molding layer M may be formed lower than a bottom surface of the light source. In another embodiment, the molding layer M may be formed to cover at least one of side surfaces or an upper surface of the light transmitting layer 114.

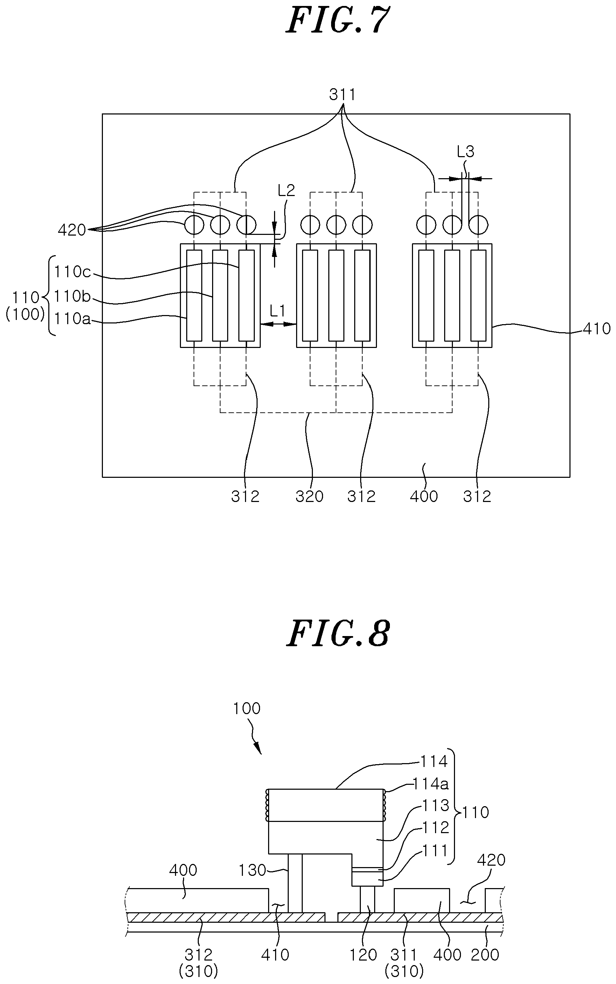

Hereinafter, a display device 1 of a second embodiment of the present disclosure will be described with reference to FIGS. 7 and 8. In explaining the second embodiment, the primary difference lies in the inclusion of a marker 400, and this difference will be the focus of the following description.

The marker 400 may be disposed on the display board 200 such that at least some of the plurality of light emitters 100 and the electrode body 300 is not covered. For example, the marker 400 may be made of an insulating material, such as PSR, silicone, photoresist, SiO₂, EMC, or polyimide. Further, the marker 400 may include a light emitting hole 410 and a plurality of electrode holes 420.

The light emitting hole 410 is a hole for exposing the light emitter 100 to the outside. A plurality of light emitting holes 410 may be formed to expose the plurality of light emitters 100 to the outside. The plurality of light emitting holes 410 may be formed in a number corresponding to the plurality of light emitters 100. Further, the plurality of light emitting holes 410 may be formed in a number corresponding to the plurality of light sources 110, or may be formed in a number less than the number of the plurality of light sources 110. The plurality of light emitting holes 410 may be arranged in a matrix form to correspond to positions of the plurality of light emitters 100, or may be spaced apart from each other in the second direction. The light generated by the plurality of light sources 110 can be emitted externally through the light emitting holes 410.

An area of the light emitting hole 410 may be formed larger than an area of the light emitter 100. Further, a size of the light emitting hole 410 may be formed differently from a size of the electrode hole 420. In other words, the area of the light emitting hole 410 may be formed larger than the area of the electrode hole 420. The light emitting holes 410 may be spaced apart from the electrode holes 420 in the first direction. A separation distance L1 between the plurality of light emitting holes 410 may be formed larger than a separation distance L2 between the plurality of first electrode holes 420 and the light emitting holes 410. The separation distance L1 between the plurality of light emitting holes 410 may be larger than a separation distance L3 between the plurality of electrode holes 420. The separation distance L2 between the light emitting hole 410 and the electrode hole 420 may be smaller than a diameter of the electrode hole 420, but is not limited thereto.

The plurality of electrode holes 420 may be arranged in a matrix form or spaced apart from each other in the second direction to be formed in the marker 400. The plurality of electrode holes 420 may expose a portion of the plurality of sub-electrodes 310 to the outside. In other words, the plurality of electrode holes 420 may expose the plurality of first sub-electrodes 311 to the outside. Further, the plurality of electrode holes 420 may have a thickness that is smaller than a thickness of the surrounding region. For example, the plurality of electrode holes 420 may be formed in a circular shape, but not limited thereto, and may be formed in various shapes, such as a square, triangle, polygon, etc. Through the electrode holes 420, a laser may be irradiated into the first sub-electrode 311 and short-circuit the first sub-electrode 311, thereby preventing a signal, current, or voltage from being supplied to the unlit light source 110.

The plurality of electrode holes 420 may be arranged spaced apart from the light emitting holes 410 in the first direction. The marker 400 may be positioned between the electrode holes 420 and the light emitting hole 410, which may prevent the plurality of light sources 110 from being affected when the first sub-electrode 311 is processed by the laser. The plurality of electrode holes 420 may be arranged to overlap with the light emitting hole 410 when projected in the first direction toward the light emitting hole 410. The separation distance L3 between the plurality of first electrode holes 420 may be equal to or smaller than the separation distance L2 between the plurality of first electrode holes 420 and the light emitting holes 410.

A height of the marker 400 may be smaller than a height of the light source 110. Thus, during external processing operations, such as laser irradiation, to short-circuit the sub-electrode 310 connected to the unlit light source 110, the position of the sub-electrode 310 located within the electrode hole 420 can be accurately identified from the outside, thereby facilitating the short-circuiting of the sub-electrode 310.

However, it is not necessarily limited thereto, and the marker 400 may also be formed to cover the light source 110 to include the electrode hole 420.

Further, a molding (not shown) may be further laminated to an upper portion of the marker 400. The molding may be a light transmissive material to allow the location of the electrode holes 420 to be externally recognizable. Thus, the sub-electrode 310 connected to the unlit light source 110 can be effectively shorted. The molding and marker 400 may be formed of different materials or may be formed of the same material. Further, the molding and the marker 400 may have different light blocking rates. On the other hand, the light emitting hole 410 and the electrode hole 420 may be formed in the molding. By such a molding, the position of the electrode hole 420 can be easily determined, so that the sub-electrode 310 connected to the unlit light source 110 can be easily short-circuited.

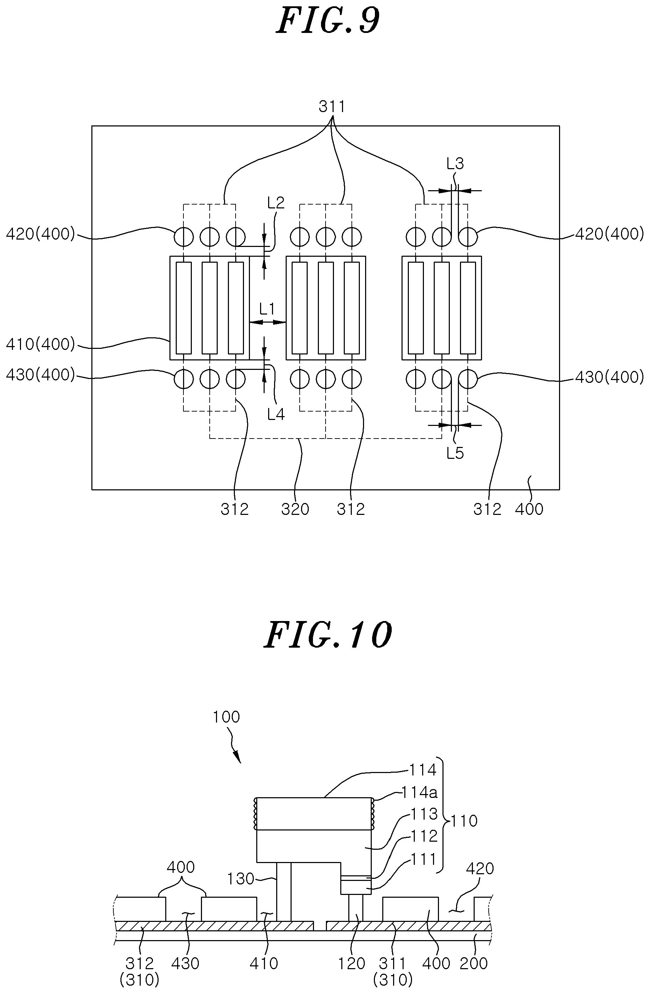

Hereinafter, with reference to FIGS. 9 and 10, a display device 1 according to a third embodiment of the present disclosure will be described.

In describing the third embodiment, the previously described electrode hole 420 is referred to as a first electrode hole 420. In addition, in describing the third embodiment, there is a difference in that a plurality of second electrode holes 430 are formed in the marker 400, and this difference will be mainly described.

The plurality of second electrode holes 430 may expose another portion of the plurality of sub-electrodes 310 to the outside. In other words, the plurality of second electrode holes 430 may expose the plurality of second sub-electrodes 312 to the outside. Through the plurality of second electrode holes 430, the laser can short-circuit the second sub-electrode 312. The plurality of second electrode holes 430 may be spaced apart from each other in the second direction and formed in the marker 400. The plurality of second electrode holes 430 may be spaced apart from the light emitting hole 410 in the first direction. As the marker 400 is positioned between the second electrode hole 430 and the light emitting hole 410, the plurality of light sources 110 may be prevented from being affected when the second sub-electrode 312 is processed by the laser.

Further, when the plurality of first electrode holes 420 are disposed to face one side of the light emitting hole 410, the plurality of second electrode holes 430 may be disposed to face the other side of the light emitting hole 410, which is opposite the first side of the light emitting hole 410. The plurality of second electrode holes 430 may be arranged to overlap with the light emitting hole 410 when projected in the first direction toward the light emitting hole 410. In other words, the light emitting hole 410 may be positioned between the plurality of first electrode holes 420 and the plurality of second electrode holes 430.

A size of the plurality of second electrode holes 430 may be formed to be the same as a size of the plurality of first electrode holes 420, but is not limited thereto. In other words, one of the second electrode hole 430 and the first electrode hole 420 may be formed larger than the other of the second electrode hole 430 and the first electrode hole 420. The second electrode hole 430 may be formed smaller than the size of the light emitting hole 410. An area of the second electrode hole 430 may be formed smaller than the area of the light emitting hole 410.

A separation distance L4 between the light emitting hole 410 and the second electrode hole 430 may be smaller than a diameter of the second electrode hole 430. A separation distance L5 between the plurality of second electrode holes 430 may be formed smaller than the separation distance L1 between the plurality of light emitting holes 410. The separation distance L5 between the plurality of second electrode holes 430 may be the same as the separation distance L3 between the plurality of first electrode holes 420. The separation distance L4 between the light emitting hole 410 and the second electrode hole 430 may be the same as the separation distance L2 between the light emitting hole 410 and the first electrode hole 420. The separation distance L4 between the plurality of second electrode holes 430 and the light emitting hole 410 may be formed to be smaller than the separation distance L1 between the plurality of light emitting holes 410. Further, a separation distance between the first electrode hole 420 and the second electrode hole 430 may be larger than the length of the light emitting hole 410 in the first direction.

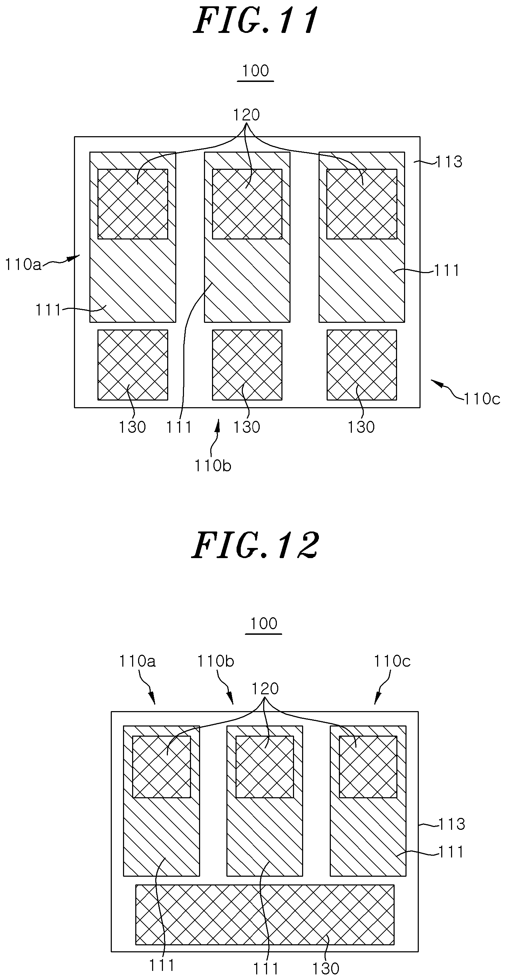

Hereinafter, with reference to FIGS. 11 and 12, a display device 1 according to a fourth embodiment of the present disclosure will be described.

In describing the fourth embodiment, there is a difference in that the second conductive semiconductor layer 113 of the plurality of light sources 110 is connected to each other to form a single unit, and this difference will be described in detail.

The second conductive semiconductor layer 113 of the plurality of light sources 110 may be connected to each other and formed integrally. In other words, the integrally formed second conductive semiconductor layer 113 may be stacked on the plurality of active layers 112. Further, the light transmitting layers 114 of the plurality of light sources 110 may be connected to each other and formed integrally, and may be laminated on the integrally formed second conductive semiconductor layer 113. By the light transmitting layer 114 and the second conductive semiconductor layer 113, the plurality of light sources 110 can be moved and disposed on the display board 200 at one time, which can increase manufacturing efficiency.

Referring to FIG. 11, in a first example, the plurality of second electrodes 130 may be electrically connected to the second conductive semiconductor layer 113 formed integrally. In this case, when an unlit light source 110 occurs, any of the first sub-electrode 311 connected to the first electrode 120 and the second sub-electrode 312 connected to the second electrode 130 may be shorted to increase the signal, current, or voltage supplied to the lit light sources 110.

Referring to FIG. 12, in a second example, the plurality of second electrodes 130 may be connected to each other and formed integrally, and electrically connected to the integrally formed second conductive semiconductor layer 113. In other words, a single second electrode 130 may be electrically connected to the integrally formed second conductive semiconductor layer 113. When an unlit light source 110 occurs with the second electrode 130 formed as one unit, the first sub-electrode 311 connected to the first electrode 120 may be shorted to increase the signal, current, or voltage supplied to the lit light source 110.

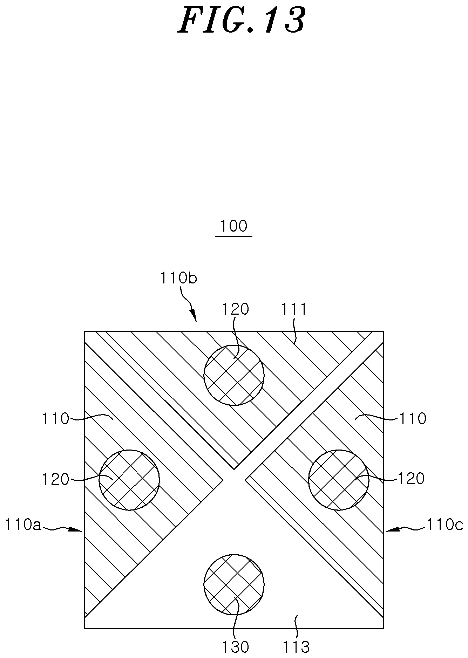

Hereinafter, with reference to FIG. 13, a display device 1 according to a fifth embodiment of the present disclosure will be described.

In describing the fifth embodiment, there is a difference in that the plurality of the first conductive semiconductor layers 111 of the plurality of light sources 110 are disposed in a radial form with respect to a center of the second conductive semiconductor layer 113, and this difference will be described in detail.

The plurality of first conductive semiconductor layers 111 of the plurality of light sources 110 may be disposed in a radial form with respect to the center of the integrally formed second conductive semiconductor layer 113. Since the plurality of first conductive semiconductor layers 111 of the plurality of light sources 110 may be disposed in a radial form, even if any one of the plurality of light sources 110 is not lit, the light generated from the lit light sources 110 may appear to be concentrated at the center, thereby preventing the unlit light source 110 from being recognized externally. Furthermore, a center portion of the light can be prevented from shifting even if one of the unlit elements is present. For example, the first conductive semiconductor layer 111 may be formed in a triangular shape, but is not limited thereto, and may also be formed in various shapes, such as circular, square, polygonal, etc.

The examples of the present disclosure have been described above as specific embodiments, but these are only examples, and the present disclosure is not limited thereto, and should be construed as having the widest scope according to the technical spirit disclosed in the present specification. A person skilled in the art may combine/substitute the disclosed embodiments to implement a pattern of a shape that is not disclosed, but it also does not depart from the scope of the present disclosure. In addition, those skilled in the art can easily change or modify the disclosed embodiments based on the present specification, and it is clear that such changes or modifications also belong to the scope of the present disclosure.

## Claims

1. A display device comprising:
a display board;
a plurality of light sources supported by the display board to generate light; and
an electrode body electrically connecting the display board and the plurality of light sources,
wherein a peak wavelength difference of the light emitted from the plurality of light sources is 5 nm or less.

2. The display device of claim 1, wherein each of the plurality of light sources includes:
a first conductive semiconductor layer;
an active layer stacked on the first conductive semiconductor layer;
a second conductive semiconductor layer stacked on the active layer; and
a light transmitting layer stacked on the second conductive semiconductor layer.

3. The display device of claim 2, wherein the plurality of light sources are arranged adjacent to each other,
wherein a ragged region is formed in the light transmitting layer, and
wherein the ragged region is formed on a surface of the light transmitting layer that faces the plurality of light sources.

4. The display device of claim 2, wherein the second conductive semiconductor layer of each of the plurality of light sources is connected to each other and integrally formed, and
wherein the light transmitting layer of each of the plurality of light sources is connected to each other and integrally formed.

5. The display device of claim 4, further comprising:
a plurality of first electrodes electrically connected to the first conductive semiconductor layers of the plurality of light sources and the electrode body; and
a plurality of second electrodes electrically connected to the second conductive semiconductor layers of the plurality of light sources and the electrode body.

6. The display device of claim 5, wherein the plurality of second electrodes are connected to each other and integrally formed.

7. The display device of claim 4, wherein the plurality of the first conductive semiconductor layers of light sources are arranged in a radial form about a center of the integrally formed second conductive semiconductor layer.

8. A display device comprising:
a display board;
a light emitter supported by the display board to generate light;
an electrode body electrically connecting the display board and the light emitter; and
a marker disposed on the display board, and including an electrode hole for exposing at least a portion of the electrode body to an outside and a light emitting hole for exposing the light emitter to the outside,
wherein the electrode hole and the light emitting hole are formed in different sizes.

9. The display device of claim 8, wherein an area of the light emitting hole is larger than an area of the electrode hole.

10. A display device comprising:
a display board;
a light emitter supported by the display board to generate light;
an electrode body electrically connecting the display board and the light emitter; and
a marker disposed on the display board, and including an electrode hole for exposing at least a portion of the electrode body to an outside and a light emitting hole for exposing the light emitter to the outside,
wherein the electrode hole and the light emitting hole are arranged to be spaced apart from each other.

11. The display device of claim 10, wherein a separation distance between the electrode hole and the light emitting hole is smaller than a diameter of the electrode hole.

12. The display device of claim 10, wherein the light emitter comprises:
a plurality of light sources connected to the electrode body to generate light,
wherein the electrode body includes:
a plurality of sub-electrodes connected to each of the light sources; and
a common electrode connected to at least a portion of the plurality of sub-electrodes, and
wherein the electrode holes are formed in plurality to expose at least a portion of the plurality of sub-electrodes to the outside.

13. The display device of claim 12, wherein each of the plurality of light sources comprises:
a first conductive semiconductor layer;
an active layer stacked on the first conductive semiconductor layer;
a second conductive semiconductor layer stacked on the active layer; and
a light transmitting layer stacked on the second conductive semiconductor layer,
wherein the light emitter further includes:
a first electrode electrically connected to the first conductive semiconductor layer; and
a second electrode electrically connected to the second conductive semiconductor layer, and
wherein the plurality of sub-electrodes include:
a plurality of first sub-electrodes connected to one of the first electrode and the second electrode; and
a plurality of second sub-electrodes connected to the other of the first electrode and the second electrode, and
wherein the plurality of electrode holes include a plurality of first electrode holes for exposing the plurality of first sub-electrodes to the outside.

14. The display device of claim 13, wherein a separation distance between the plurality of first electrode holes is smaller than or equal to a separation distance between the light emitting hole and the plurality of first electrode holes.

15. The display device of claim 13, wherein the light emitter and the light emitting holes are formed in plurality and are spaced apart from each other, and
wherein a separation distance between the plurality of light emitting holes is larger than a separation distance between the plurality of first electrode holes.

16. The display device of claim 15, wherein the separation distance between the plurality of light emitting holes is larger than the diameter of the electrode hole.

17. The display device of claim 15, wherein a direction in which the plurality of light emitting holes are arranged is the same as a direction in which the plurality of first electrode holes are arranged.

18. The display device of claim 13, wherein the plurality of electrode holes includes:
a plurality of second electrode holes for exposing the plurality of second sub-electrodes to the outside.

19. The display device of claim 18, wherein the light emitting hole is located between the plurality of first electrode holes and the plurality of second electrode holes.

20. The display device of claim 18, wherein the light emitter and the light emitting holes are formed in plurality and are spaced apart from each other, and
wherein a separation distance between the plurality of light emitting holes is smaller than a separation distance between the first electrode hole and the second electrode hole.
